# EUROPEAN PATENT APPLICATION

(11) **EP 4 793 988 A1**
(43) Date of publication of application: **19.08.2026**
(21) Application number: 24881012.9
(22) Date of filing: 27.05.2024
(51) Int. Cl.: H01L 21/265, H10D 30/60

(54) **SEMICONDUCTOR DEVICE, PREPARATION METHOD, AND ELECTRONIC DEVICE**

(30) Priority: 27.10.2023 CN 202311417684
(71) Applicant: HUAWEI TECHNOLOGIES CO., LTD., Shenzhen 518129 (CN)
(72) Inventor: LI, Wenchang, Shenzhen, Guangdong 518129 (CN); LIU, Lei, Shenzhen, Guangdong 518129 (CN); CHANG, Yuan, Shenzhen, Guangdong 518129 (CN); ZHANG, Shuo, Shenzhen, Guangdong 518129 (CN); YU, Deqin, Shenzhen, Guangdong 518129 (CN); YAO, Yuan, Shenzhen, Guangdong 518129 (CN); WEI, Qingsong, Shenzhen, Guangdong 518129 (CN)
(74) Representative: MERH-IP Matias Erny Reichl Hoffmann Patentanwälte PartG mbB
(86) International application number: PCT/CN2024/095562
(87) International publication number: WO 2025/086633

(57) **Abstract**

This application discloses a semiconductor device, a preparation method, and an electronic device. The semiconductor device includes a semiconductor substrate, a first barrier layer, a metal silicide layer, a gate stack structure, and gate spacers. The semiconductor substrate includes a channel region and a source region and a drain region that are located on two sides of the channel region. The first barrier layer is located on the source region and the drain region. The metal silicide layer covers a side that is of the first barrier layer on the source region and the drain region and that faces away from the semiconductor substrate. Recesses are formed in the source region and the drain region, and a first semiconductor material is filled in the recesses. The first barrier layer includes a second semiconductor material doped with first dopant ions. A lattice structure of a material of the metal silicide layer is different from a lattice structure of the first semiconductor material. Through this arrangement, the first barrier layer is disposed between the metal silicide layer and the first semiconductor material, so that material agglomeration and precipitation caused by direct contact between the first semiconductor material and the metal silicide layer can be avoided, thereby improving performance of the semiconductor device.

## Description

### CROSS-REFERENCE TO RELATED APPLICATIONS

This application claims priority to Chinese Patent Application No. 202311417684.0, filed with the China National Intellectual Property Administration on October 27, 2023 and entitled "SEMICONDUCTOR DEVICE, PREPARATION METHOD, AND ELECTRONIC DEVICE", which is incorporated herein by reference in its entirety.

### TECHNICAL FIELD

This application relates to the field of semiconductor technologies, and in particular, to a semiconductor device, a preparation method, and an electronic device.

### BACKGROUND

In semiconductor manufacturing, for a metal-oxide-semiconductor field-effect transistor (Metal-oxide-semiconductor field-effect transistor, MOSFET) device, carriers of an N-type metal-oxide-semiconductor field-effect transistor (N-type metal-oxide-semiconductor field-effect transistor, NMOS) are electrons, whereas carriers of a P-type metal-oxide-semiconductor field-effect transistor (P-type metal-oxide-semiconductor field-effect transistor, PMOS) are holes. Effective mass of the holes is greater than effective mass of the electrons. Therefore, mobility of the holes is greatly lower than that of the electrons. To maintain equilibrium of carriers in the MOSFET and improve a speed of the PMOS, hole mobility needs to be improved. Based on this, a SiGe material is epitaxially grown in source region/drain region of a semiconductor substrate, so that a lateral compressive stress is generated, thereby squeezing a channel, reducing a lattice constant in the channel, and improving the hole mobility.

In addition, to avoid non-ohmic contact caused by direct contact between metal and a semiconductor portion (for example, the source region/drain region) in the transistor, a metal silicide is usually used as a transition layer for contact between the metal and the semiconductor portion (for example, the source region/drain region). For example, metal is covered on the SiGe material in the source region/drain region, and then the metal silicide is formed through a thermal reaction, to achieve interconnection. However, some metal silicides have crystal structures different from that of the SiGe material. After these metal silicides are formed on the SiGe material, Ge agglomeration and precipitation occur, resulting in stress loss in the SiGe material and greatly affecting performance of a semiconductor device.

### SUMMARY

Embodiments of this application provide a semiconductor device, a preparation method, and an electronic device, to avoid material agglomeration and precipitation and improve performance of the semiconductor device.

According to a first aspect, an embodiment of this application provides a semiconductor device. The semiconductor device includes a semiconductor substrate, a first barrier layer, a metal silicide layer, a gate stack structure, and gate spacers. The semiconductor substrate includes a channel region and a source region and a drain region that are located on two sides of the channel region. The first barrier layer is located on the source region and the drain region. The metal silicide layer covers a side that is of the first barrier layer on the source region and the drain region and that faces away from the semiconductor substrate. The gate stack structure is located on the channel region. The gate stack structure includes a gate dielectric layer and a gate. The gate dielectric layer is located between the gate and the channel region. The gate spacers are located on two sides of the gate stack structure, and an orthographic projection of the gate spacer onto the semiconductor substrate does not overlap an opening portion of a recess. In addition, recesses are formed in the source region and the drain region. A first semiconductor material is filled in the recesses. Orthographic projections of the first barrier layer onto the semiconductor substrate respectively overlap orthographic projections of opening portions of the recess in the source region and the recess in the drain region onto the semiconductor substrate. In addition, the first barrier layer includes a second semiconductor material doped with first dopant ions. A lattice structure of a material of the metal silicide layer is different from a lattice structure of the first semiconductor material. Through this arrangement, the first barrier layer is disposed between the metal silicide layer and the first semiconductor material, so that material agglomeration and precipitation caused by direct contact between the first semiconductor material and the metal silicide layer can be avoided, thereby improving performance of the semiconductor device. In addition, the first barrier layer and the metal silicide layer are sequentially disposed on the source region and the drain region, so that a source metal connection line and a drain metal connection line are electrically connected to the source region and the drain region, respectively, through the first barrier layer and the metal silicide layer, thereby reducing contact resistance.

In some embodiments, the second semiconductor material includes Si. In addition, the semiconductor device is a P-type transistor, and the first dopant ions are B ions, or the first dopant ions are B ions and C ions. A doping concentration (volume density) of the B ions is approximately 1e²¹ to 8e²¹ ions per cubic centimeter.

In some embodiments, the metal silicide layer includes one or more of cobalt silicide, nickel silicide, or titanium silicide.

In some embodiments, the semiconductor device is the P-type transistor, and the first semiconductor material includes a silicon-germanium material, to improve a hole mobility rate of the P-type transistor.

In some embodiments, a second barrier layer is further included. The second barrier layer is located between the first barrier layer on the source region and the drain region and the metal silicide layer. In addition, the second barrier layer includes a third semiconductor material doped with second dopant ions. Through this arrangement, the second barrier layer can further inhibit growth of a metal silicide toward the first semiconductor material, and improve thermal stability of the semiconductor device.

In some embodiments, the third semiconductor material is the same as the second semiconductor material.

In some embodiments, the second dopant ions include C ions.

In some embodiments, the gate stack structure further includes a metal silicide layer covering a side that is of the gate and that faces away from the semiconductor substrate. Through this arrangement, when a gate metal connection line is formed, the gate metal connection line can be electrically connected to the gate through the metal silicide layer, thereby reducing contact resistance.

In some embodiments, to achieve channel-squeezing effect and improve hole mobility of the P-type transistor, in a direction from the bottom of the recess to the opening portion of the recess, a cross-sectional area of the recess at a first cross section gradually increases to a target cross-sectional area and then gradually decreases from the target cross-sectional area. The first cross section is parallel to a plane on which the opening portion of the recess is located, and the first cross section is located between the opening portion and the bottom of the recess.

According to a second aspect, an embodiment of this application further provides an electronic device. The electronic device includes a circuit board and a semiconductor device, and the semiconductor device is disposed on the circuit board and electrically connected to the circuit board. The semiconductor device is the semiconductor device according to the first aspect or the implementations of the first aspect. Because performance of the semiconductor device is good, performance of the electronic device including the semiconductor device is good as well. In addition, a problem-resolving principle of the electronic device is similar to that of the semiconductor device. Therefore, for implementation of the electronic device, refer to the implementation of the semiconductor device. Details are not described herein again.

According to a third aspect, an embodiment of this application further provides a method for preparing a semiconductor device. The preparation method includes: forming a gate stack structure on a channel region of a semiconductor substrate, and gate spacers located on two sides of the gate stack structure, where the gate stack structure includes a gate dielectric layer and a gate, the gate dielectric layer is located between the gate and the channel region, and an orthographic projection of the gate spacer onto the semiconductor substrate does not overlap an opening portion of a recess; etching recesses in a source region and a drain region of the semiconductor substrate, respectively; epitaxially growing a first semiconductor material in the recesses; and performing ion doping in the source region and the drain region of the semiconductor substrate, and forming a first barrier layer and a metal silicide on the source region and the drain region, where orthographic projections of the first barrier layer onto the semiconductor substrate respectively overlap orthographic projections of opening portions of the recess in the source region and the recess in the drain region onto the semiconductor substrate, the first barrier layer includes a second semiconductor material doped with first dopant ions, and the metal silicide layer covers a side that is of the first barrier layer on the source region and the drain region and that faces away from the semiconductor substrate.

For forming the metal silicide layer, for example, the performing ion doping in the source region and the drain region of the semiconductor substrate and forming the first barrier layer and the metal silicide on the source region and the drain region includes the following process: epitaxially forming a silicon capping layer doped with B ions on the source region and the drain region, where orthographic projections of the silicon capping layer onto the semiconductor substrate respectively overlap the orthographic projections of the opening portions of the recess in the source region and the recess in the drain region onto the semiconductor substrate, and a current doping concentration of the B ions in the silicon capping layer ranges from 8e²⁰ ions per cubic centimeter to 8e²¹ ions per cubic centimeter; performing doping with the B ion in the source region, the drain region, and the silicon capping layer of the semiconductor substrate, where a current doping concentration of the B ions in the silicon capping layer ranges from 1e²¹ ions per cubic centimeter to 8e²¹ ions per cubic centimeter; performing, by using noble gas ions, pre-amorphization implant treatment on at least one side that is of the silicon capping layer and that faces away from the semiconductor substrate, to form an amorphous silicon layer on the side that is of the silicon capping layer and that faces away from the semiconductor substrate; and forming the metal silicide layer by performing a self-aligned silicide process on the amorphous silicon layer.

To further inhibit growth of the metal silicide and improve thermal stability of the semiconductor device, after the performing, by using the noble gas ions, the pre-amorphization implant treatment on at least one side that is of the silicon capping layer and that faces away from the semiconductor substrate, to form the amorphous silicon layer on the side that is of the silicon capping layer and that faces away from the semiconductor substrate, the preparation method further includes the following process: implanting C ions into the amorphous silicon layer. In addition, forming the metal silicide layer by performing the self-aligned silicide process on the amorphous silicon layer includes the following process: forming the metal silicide layer by performing the self-aligned silicide process on the amorphous silicon layer, to form a second barrier layer between the metal silicide and the first barrier layer.

### BRIEF DESCRIPTION OF DRAWINGS

FIG. 1 is a diagram of a structure of an electronic device according to an embodiment of this application;
FIG. 2 is a diagram of a structure of a semiconductor device according to an embodiment of this application;
FIG. 3 is a diagram of another structure of a semiconductor device according to an embodiment of this application;
FIG. 4a to FIG. 4f are diagrams of structures of a semiconductor device in a preparation process according to an embodiment of this application;
FIG. 5 is a diagram of another structure of a semiconductor device according to an embodiment of this application; and
FIG. 6a and FIG. 6b are respectively diagrams of other structures of a semiconductor device in a preparation process according to an embodiment of this application.

### Reference numerals:

100: housing; 200: circuit board; 300: semiconductor device; 310: semiconductor substrate; 320: first semiconductor material; 320': silicon-germanium material; 330: first barrier layer; 331/332: amorphous silicon layer; 330': silicon capping layer; 340/353: metal silicide layer; 350: gate stack structure; 351: gate dielectric layer; 352: gate; 360: gate spacer; 370: metal layer; 371: source metal connection line; 372: drain metal connection line; 373: gate metal connection line; 374: isolation layer; GB: channel region; SB: source region; DB: drain region; AX1/AX2: recess.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in the descriptions of this application, "a plurality of" is understood as "at least two". In addition, it should be understood that in the descriptions of this application, terms such as "first" and "second" are merely used for distinguishing and description, but should not be understood as indicating or implying relative importance, or should not be understood as indicating or implying a sequence.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not indicate an actual scale.

To facilitate understanding of a semiconductor device, a preparation method, and an electronic device that are provided in embodiments of this application, the following first describes an application scenario of the semiconductor device, the preparation method, and the electronic device. The semiconductor device provided in embodiments of this application may be widely used in various electronic devices, and the electronic device includes various terminal devices and electronic components. The terminal device may include but is not limited to a device, for example, a smartphone, a smart television, a smart television set-top box, a smartwatch, a personal computer (personal computer, PC), a wearable device, or a smart broadband. The electronic component includes but is not limited to a communication device, for example, a wireless network, a fixed network, and a server, and a component, for example, a component module, a memory, a static random access memory, and a digital logic circuit, which are not listed one by one herein. It may be understood that a specific implementation of the semiconductor device may be determined based on an actual application scenario. This is not limited in this application.

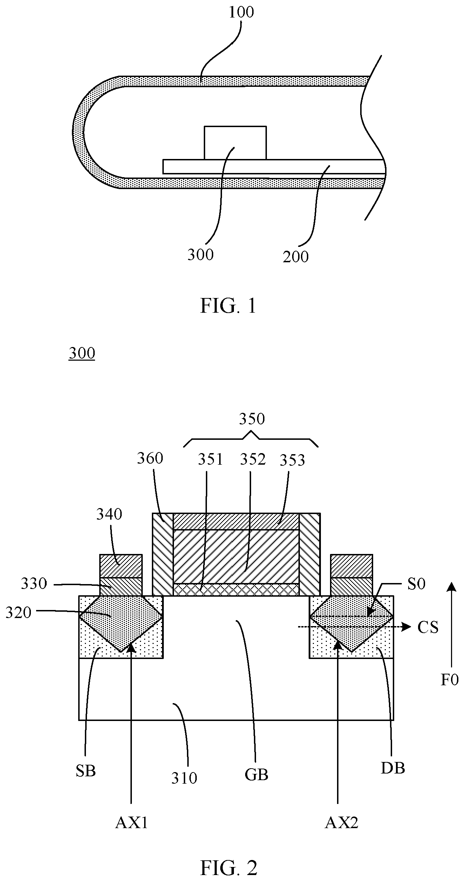

FIG. 1 is a diagram of a structure of an electronic device according to an embodiment of this application. Refer to FIG. 1. The electronic device includes a housing 100, a circuit board 200 disposed in the housing 100, and a semiconductor device 300 fastened on the circuit board 200. The semiconductor device 300 and the circuit board 200 may be connected through bonding, wire bonding, or the like, to implement an electrical connection between the semiconductor device 300 and the circuit board 200, so that signal transmission can be performed between the semiconductor device 300 and the circuit board 200.

FIG. 2 is a diagram of a structure of a semiconductor device according to an embodiment of this application. Refer to FIG. 2. A semiconductor device 300 includes a semiconductor substrate 310, and a first barrier layer 330, a metal silicide layer 340, a gate stack structure 350, and gate spacers 360 that are located on a same side of the semiconductor substrate 310. The semiconductor substrate 310 includes a channel region GB and a source region SB and a drain region DB that are located on two sides of the channel region GB. The gate stack structure 350 is located on the channel region GB. The gate spacers 360 are located on two sides of the gate stack structure 350. To improve performance of the semiconductor device, a recess AX1 is formed in the source region SB, and a recess AX2 is formed in the drain region DB. The recesses AX1 and AX2 are respectively filled with a first semiconductor material 320, to generate a lateral compressive stress and achieve channel-squeezing effect. In addition, the gate stack structure 350 includes a gate dielectric layer 351 and a gate 352. The gate dielectric layer 351 is located between the gate 352 and the channel region GB. An orthographic projection of the gate spacer 360 onto the semiconductor substrate 310 does not overlap an opening portion of the recess. In addition, the first barrier layer 330 is located on the source region SB and the drain region DB, and orthographic projections of the first barrier layer 330 onto the semiconductor substrate 310 respectively overlap orthographic projections of opening portions of the recess in the source region SB and the recess in the drain region DB onto the semiconductor substrate 310. The metal silicide layer 340 covers a side that is of the first barrier layer 330 on the source region SB and the drain region DB and that faces away from the semiconductor substrate 310. A lattice structure of a material of the metal silicide layer 340 is different from a lattice structure of the first semiconductor material 320, the first barrier layer 330 is disposed between the metal silicide layer 340 and the first semiconductor material 320, and the first barrier layer 330 includes a second semiconductor material doped with first dopant ions. Therefore, material agglomeration and precipitation caused by direct contact between the first semiconductor material 320 and the metal silicide layer 340 can be avoided, thereby improving the performance of the semiconductor device. In addition, the first barrier layer 330 and the metal silicide layer 340 are sequentially disposed on the source region SB and the drain region DB, so that a source metal connection line and a drain metal connection line can be electrically connected to the source region SB and the drain region DB, respectively, through the first barrier layer 330 and the metal silicide layer 340, thereby reducing contact resistance.

Still refer to FIG. 2. The gate stack structure 350 further includes a metal silicide layer 353 covering a side that is of the gate 352 and that faces away from the semiconductor substrate 310. Through this arrangement, when a gate metal connection line is formed, the gate metal connection line can be electrically connected to the gate 352 through the metal silicide layer 340, thereby reducing contact resistance.

Still refer to FIG. 2. An orthographic projection of the gate 352 onto the semiconductor substrate 310 is located within an orthographic projection of the channel region GB onto the semiconductor substrate 310. Alternatively, an orthographic projection of the gate 352 onto the semiconductor substrate 310 overlaps an orthographic projection of the channel region GB onto the semiconductor substrate 310.

Still refer to FIG. 2. An orthographic projection that is of the gate spacer 360 and that is close to the source region SB onto the semiconductor substrate 310 further overlaps a partial region that is of an orthographic projection of the source region SB onto the semiconductor substrate 310 and that is located on a side close to the orthographic projection of the gate onto the semiconductor substrate 310, and an orthographic projection that is of the gate spacer 360 and that is close to the drain region DB onto the semiconductor substrate 310 further overlaps a partial region that is of an orthographic projection of the drain region DB onto the semiconductor substrate 310 and that is located on a side close to the orthographic projection of the gate onto the semiconductor substrate 310. Alternatively, an orthographic projection that is of the gate spacer 360 and that is close to the source region SB onto the semiconductor substrate 310 may be located within the orthographic projection of the channel region GB onto the semiconductor substrate 310, and an orthographic projection of that is of the gate spacer 360 and that is close to the drain region DB onto the semiconductor substrate 310 may be located within the orthographic projection of the channel region GB onto the semiconductor substrate 310.

The semiconductor device in this embodiment of this application may be disposed as a P-type transistor (for example, a PMOS). To improve hole mobility of the P-type transistor, because a lattice constant (5.653 Å) of Ge is greater than a lattice constant (5.431 Å) of Si, a silicon-germanium (SiGe) material is epitaxially grown in the recesses in the source region SB and the drain region DB of the semiconductor substrate 310, to generate the lateral compressive stress, thereby squeezing a channel, reducing a lattice constant in the channel, and improving the hole mobility. Based on this, the first semiconductor material 320 may be disposed as the silicon-germanium material. Particularly in a chip manufacturing process below 45 nm, a hole mobility rate of the P-type transistor can be improved by filling the recesses with the silicon-germanium material. Certainly, during specific application, the first semiconductor material 320 may alternatively be another material that can achieve channel squeezing. This is not limited herein.

During specific implementation, the metal silicide layer 340 includes one or more of cobalt silicide (CoSi₂), nickel silicide (NiSi), and titanium silicide (TiSi). It may be understood that the nickel silicide has poor thermal stability and degrades at a high temperature above 500 degrees Celsius, which limits use of the nickel silicide in some high-temperature processes. The cobalt silicide has advantages of good conductivity and low mismatch with silicon. In addition, CoSi₂ is a final phase of the cobalt silicide and has thermal stability approximately 150 degrees Celsius higher than that of NiSi. In this way, CoSi₂ is well used in some scenarios in which the semiconductor device needs to be used in high-temperature thermal stability. Based on this, in this embodiment of this application, when the semiconductor device needs to be used in the high-temperature thermal stability scenario, the material of the metal silicide layer 340 may be preferentially selected as cobalt silicide (CoSi₂). Further, in the chip manufacturing process below 45 nm, the metal silicide layer 340 is formed by using cobalt silicide (CoSi₂), so that a prepared semiconductor device can be used for a long time at a high temperature, avoiding degradation of a NiSi material at the high temperature.

In this application, the second semiconductor material is disposed as Si. If the first dopant ions are disposed as B ions, the first barrier layer 330 is a film layer doped with the B ions in Si. Alternatively, if the first dopant ions are disposed as B ions and C ions, the first barrier layer 330 is a film layer doped with the B ions and the C ions in Si. In addition, the B ions may have a higher doping concentration, so that growth of a metal silicide is inhibited in a preparation process, and contact between the metal silicide and the first semiconductor material 320 is further avoided. Certainly, specific doping concentrations of the B ions and the C ions may be determined according to an actual process requirement. This is not limited herein.

Still refer to FIG. 2. To achieve the channel-squeezing effect and improve the hole mobility of the P-type transistor, the recess AX2 is used as an example. In a direction F0 (that is, a direction pointed by an arrow F0) from the bottom of the recess AX2 to the opening portion of the recess AX2, a cross-sectional area of the recess AX2 at a first cross section CS gradually increases to a target cross-sectional area S0 and then gradually decreases from the target cross-sectional area S0. In addition, the first cross section CS is parallel to a plane on which the opening portion of the recess AX2 is located, and the first cross section CS is located between the opening portion and the bottom of the recess AX2. Through this arrangement, in the direction F0 (that is, the direction pointed by the arrow F0) from the bottom of the recess AX2 to the opening portion of the recess, the cross-sectional area of the recess AX2 at the first cross section CS can exhibit a trend of first increasing and then decreasing. The recess AX1 may be disposed similarly. Details are not described herein.

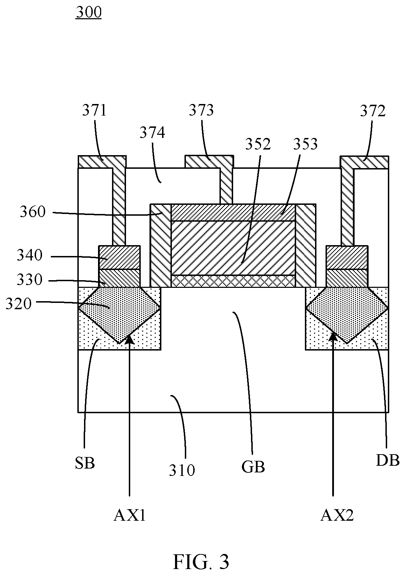

FIG. 3 is a diagram of another structure of a semiconductor device according to an embodiment of this application. Refer to FIG. 3. To achieve interconnection, the semiconductor device 300 further includes an isolation layer 374, a source metal connection line 371, a drain metal connection line 372, and a gate metal connection line 373. The isolation layer 374 covers a side that is of a semiconductor substrate 310 and that has a gate stack structure 350, and the isolation layer 374 includes a source contact hole, a drain contact hole, and a gate contact hole that are penetrated. The source contact hole is configured to expose a metal silicide layer 340 on a source region SB, the drain contact hole is configured to expose a metal silicide layer 340 on a drain region DB, and the gate contact hole is configured to expose the metal silicide layer 340 on a gate. In addition, the source metal connection line 371 is in contact with the metal silicide layer 340 on the source region SB through the source contact hole, so that the source metal connection line 371 can be connected to the source region SB through the metal silicide layer 340 and the first barrier layer 330 on the source region SB, thereby reducing contact resistance and achieving signal transmission. Moreover, the drain metal connection line 372 is in contact with the metal silicide layer 340 on the drain region DB through the drain contact hole, so that the drain metal connection line 372 can be connected to the drain region DB through the metal silicide layer 340 and the first barrier layer 330 on the drain region DB, thereby reducing contact resistance and achieving signal transmission. Furthermore, the gate metal connection line 373 is in contact with a metal silicide on the gate through the gate contact hole, so that the gate metal connection line 373 can be connected to the gate through the metal silicide, thereby reducing contact resistance and achieving signal transmission.

The following describes a method for preparing a semiconductor device provided in an embodiment of this application by using the structure of the semiconductor device shown in FIG. 2 as an example. Specifically, the method for preparing the semiconductor device provided in this embodiment of this application may include the following content.

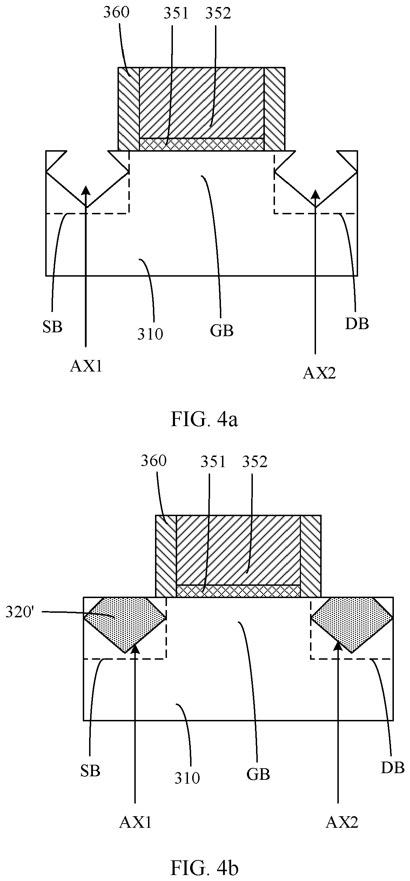

Refer to FIG. 4a. FIG. 4a is a diagram of a structure of a semiconductor device in a preparation process according to an embodiment of this application. For example, a semiconductor substrate 310 is provided. A gate stack structure 350 and gate spacers 360 located on two sides of the gate stack structure 350 are formed on a channel region GB of the semiconductor substrate 310. Then, the gate spacers 360 are formed on two sides of a gate 352. Materials of a gate dielectric layer 351 and the gate spacer 360 include but are not limited to one or more of silicon dioxide and silicon nitride. A material of the gate 352 includes but is not limited to polycrystalline silicon. Then, recesses are respectively formed in a source region SB and a drain region DB through etching by using an etching process. For example, a dry etcher and a selective wet etching solution may be employed. An etching solution includes but is not limited to tetramethylammonium hydroxide (Tetramethylammonium hydroxide, TMAH). Dry etching and wet etching are respectively performed on the source region SB and the drain region DB, to form the recesses in the source region SB and the drain region DB. In addition, the semiconductor substrate 310 includes but is not limited to a silicon substrate.

Refer to FIG. 4b. FIG. 4b is a diagram of another structure of the semiconductor device in the preparation process according to an embodiment of this application. For example, a first semiconductor material 320 is epitaxially grown in the recess. For example, the first semiconductor material 320 is a silicon-germanium material, and an epitaxial growth device may be employed to epitaxially grow the silicon-germanium material 320' in the recess.

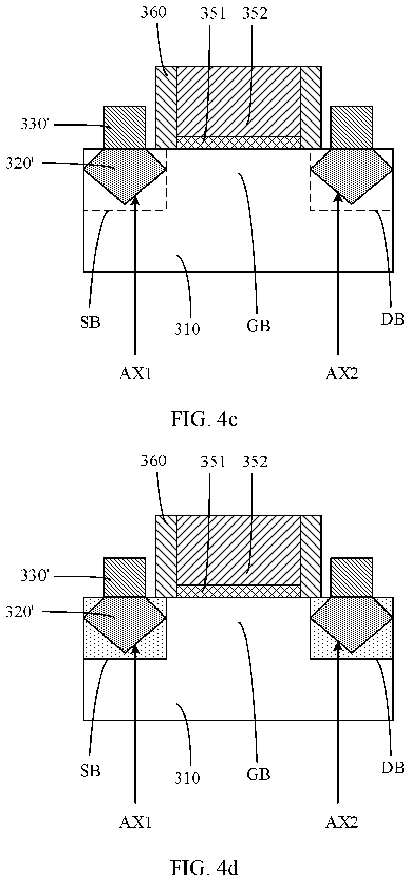

Refer to FIG. 4c. FIG. 4c is a diagram of another structure of the semiconductor device in the preparation process according to an embodiment of this application. For example, the epitaxial growth device may be employed, and when a silicon capping layer 330' is epitaxially grown, B ions are doped into the silicon capping layer 330' by adding a boride (for example, borane B₂H₆), such that orthographic projections of the formed silicon capping layer 330' onto the semiconductor substrate 310 respectively overlap orthographic projections of opening portions of the recess in the source region SB and the recess in the drain region DB onto the semiconductor substrate 310. In addition, a concentration of the B ions in the silicon capping layer 330' is increased by increasing an addition ratio of the boride, so that a current doping concentration of the B ions in the silicon capping layer 330' ranges from 8e²⁰ to 8e²¹ ions per cubic centimeter. In addition, a thickness of the silicon capping layer 330' may range from 15 nm to 30 nm. It may be understood that, when the silicon capping layer 330' is epitaxially grown, C ions may also be doped into the silicon capping layer 330' when the B ions are doped into the silicon capping layer 330', or the C ions are directly doped into the silicon capping layer 330'. A concentration of the C ions in the silicon capping layer 330' is increased by adjusting the concentration of the C ions.

Refer to FIG. 4d. FIG. 4d is a diagram of another structure of the semiconductor device in the preparation process according to an embodiment of this application. For example, an ion implantation device may be employed, and B ions are implanted into the source region SB and the drain region DB of the semiconductor substrate 310, forming the source region SB and the drain region DB doped with the B ions. When the B ions are implanted into the source region SB and the drain region DB, the B ions are further implanted into the silicon capping layer 330', so that the concentration of the B ions in the silicon capping layer 330' is increased, and content of the B ions at the bottom of the silicon capping layer 330' is further improved, to form a boron barrier layer. In addition, in this step, implantation energy of the B ions is approximately 2 to 4 kilo-electron volts, and an implantation dose of the B ions ranges from 2e¹⁵ to 5e¹⁵ ions per square centimeter, such that after this step, the doping concentration of the B ions in the doped silicon capping layer 330' ranges from 1e²¹ to 8e²¹ ions per cubic centimeter. Then, a spike annealing process is performed by using a spike annealing device, and laser surface annealing is performed by using a laser annealing device, to diffuse and activate the B ions implanted into the source region SB and the drain region DB. In addition, the channel region GB is formed in a region between the source region SB and the drain region DB.

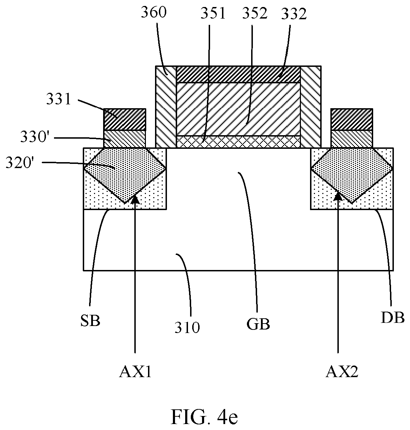

Refer to FIG. 4e. FIG. 4e is a diagram of another structure of the semiconductor device in the preparation process according to an embodiment of this application. For example, the ion implantation device is employed to perform pre-amorphization implant (Pre-amorphization implant, PAI) treatment, by implanting noble gas ions, on a side that is of the silicon capping layer 330' and that faces away from the semiconductor substrate 310, so that a more stable amorphous silicon layer 331 is formed in a region on the side that is of the silicon capping layer 330' and that faces away from the semiconductor substrate 310, and the silicon capping layer 330' doped with the B ions further exists between the amorphous silicon layer 331 and the semiconductor substrate 310, to facilitate formation of a metal silicide in a subsequent step. In addition, the PAI processing is performed by using the noble gas ions. This can also help improve density and continuity of a subsequently formed metal silicide thin film, thereby improving interface morphology, reducing defects, and effectively mitigating agglomeration of the silicon-germanium material 320'. In addition, the noble gas ions may be further used to perform the pre-amorphization implant treatment on a side that is of the gate and that faces away from the semiconductor substrate 310 through the ion implantation, so that a more stable amorphous silicon layer 332 is formed in a region on the side that is of the gate and that faces away from the semiconductor substrate 310. During specific implementation, the noble gas ions include, for example, Xe ions and/or Ar ions. If pre-amorphization implantation source uses Xe ions, implantation energy of the Xe ions is approximately 2 to 10 kilo-electron volts, and an implantation dose of the Xe ions approximately ranges from 1e¹⁴ to 5e¹⁴ ions per square centimeter. It may be understood that the Xe ions are used to replace conventional Ge ions in the pre-amorphization implant treatment. This can avoid agglomeration caused by incompatibility between Ge and a cobalt-germanium material.

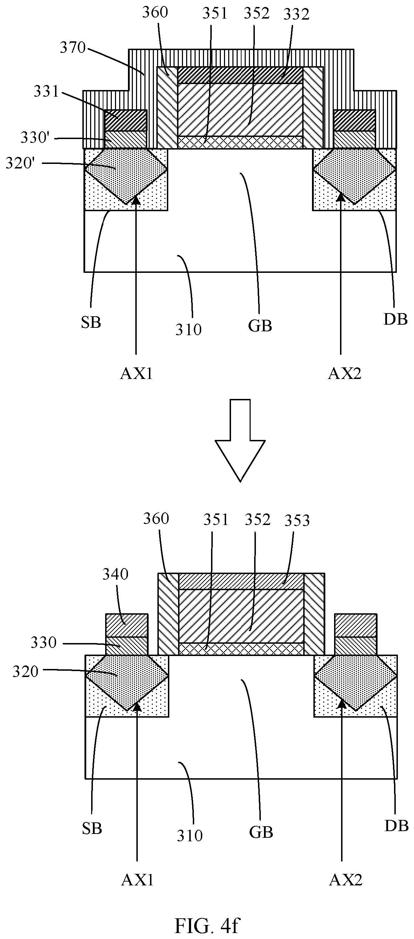

Refer to FIG. 4f. FIG. 4f is a diagram of another structure of the semiconductor device in the preparation process according to an embodiment of this application. For example, a self-aligned silicide process is performed on the amorphous silicon layer 331 to form a metal silicide layer 340. Specifically, a deposition process (for example, a physical vapor deposition process based on a physical vapor deposition device) is employed to deposit a metal layer 370 on the side that is of the silicon capping layer 330' and that faces away from the semiconductor substrate 310, and a thickness of the metal layer 370 approximately ranges from 40 to 80 nanometers. Then, a rapid thermal annealing device is employed to form a high-resistivity metal silicide layer through low-temperature rapid thermal annealing. Then, a wet etcher is employed to remove a remaining unreacted metal layer through selective etching (a selective etching solution is sulfuric acid). Then, the rapid thermal annealing device is employed to form a low-resistance metal silicide layer through high-temperature rapid thermal annealing. If the metal layer is a cobalt metal layer, the metal silicide is cobalt silicide. An annealing temperature corresponding to low-temperature rapid thermal annealing is approximately 380 to 540 degrees Celsius, and an annealing time is approximately 30 to 120 seconds. An annealing temperature corresponding to high-temperature rapid thermal annealing is approximately 700 to 900 degrees Celsius, and an annealing time is approximately 5 to 30 seconds. If the metal layer is a nickel metal layer, the metal silicide is nickel silicide. An annealing temperature corresponding to low-temperature rapid thermal annealing is approximately 200 to 300 degrees Celsius, and an annealing time is approximately 30 to 60 seconds. An annealing temperature corresponding to high-temperature rapid thermal annealing is approximately 300 to 550 degrees Celsius, and an annealing time is approximately 5 to 30 seconds. If the metal layer is a titanium metal layer, the metal silicide is titanium silicide. Annealing temperatures and annealing times corresponding to low-temperature rapid thermal annealing and high-temperature rapid thermal annealing may be determined according to a process requirement.

It may be understood that an example in which the metal silicide is the cobalt silicide is used. Because the B ions are doped into the silicon capping layer 330', growth of the cobalt silicide is inhibited during formation of the cobalt silicide, so that a thickness of a cobalt silicide layer is reduced, agglomeration and precipitation caused by direct contact between the cobalt silicide layer and a silicon-germanium material in the recess is avoided, and performance of the semiconductor device is improved. In addition, when the silicon capping layer 330' is epitaxially grown, the doping concentration of the B ions in the silicon capping layer 330' is increased, so that the growth of the cobalt silicide can be further inhibited, and direct contact between the cobalt silicide layer and the silicon-germanium material in the recess is avoided. Further, when ions are implanted into the source region SB and the drain region DB, the concentration of the B ions in the silicon capping layer 330' is further improved, so that the growth of the cobalt silicide to a side of the semiconductor substrate 310 can be further inhibited, and direct contact between the cobalt silicide layer and the silicon-germanium material in the recess is further avoided.

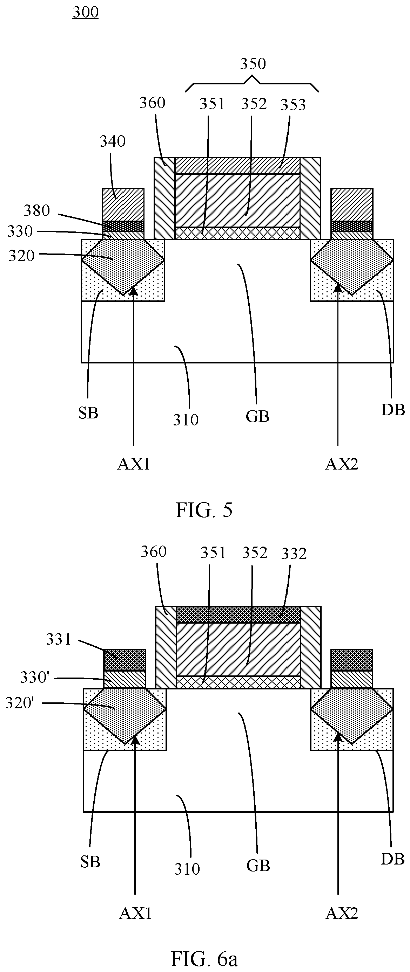

FIG. 5 is a diagram of another structure of a semiconductor device according to an embodiment of this application. Refer to FIG. 5. The semiconductor device 300 includes a semiconductor substrate 310, and a first barrier layer 330, a metal silicide layer 340, a gate stack structure 350, gate spacers 360, and a second barrier layer 380 that are located on a same side of the semiconductor substrate 310. The second barrier layer 380 is located between the first barrier layer 330 on a source region SB and a drain region DB and the metal silicide layer 340, and the second barrier layer 380 includes a third semiconductor material doped with second dopant ions. For example, the third semiconductor material is the same as a second semiconductor material. For example, both the second semiconductor material and the third semiconductor material are Si, and the second dopant ions include but are not limited to C ions. Through this arrangement, the second barrier layer 380 can further inhibit growth of the metal silicide toward a first semiconductor material 320, and improve thermal stability of the semiconductor device.

The following describes a method for preparing a semiconductor device provided in an embodiment of this application by using the structure of the semiconductor device shown in FIG. 5 as an example. The method for preparing the semiconductor device provided in this embodiment of this application includes processes shown in FIG. 4a to FIG. 4e and also includes the following content.

Refer to FIG. 6a. FIG. 6a is a diagram of another structure of a semiconductor device in a preparation process according to an embodiment of this application. For example, an ion implantation device is employed to implant C ions into a source region SB, a drain region DB, and an amorphous silicon layer 331 on a gate, to form the amorphous silicon layer 331 doped with the C ions. Implantation energy of the C ions is approximately 2 to 5 kilo-electron volts, and an implantation dose of the C ions approximately ranges from 2e¹⁴ to 1e¹⁵ ions per square centimeter. Based on this, a second barrier layer 380 further inhibits downward growth of a metal silicide (for example, cobalt silicide), thereby further improving thermal stability of the device.

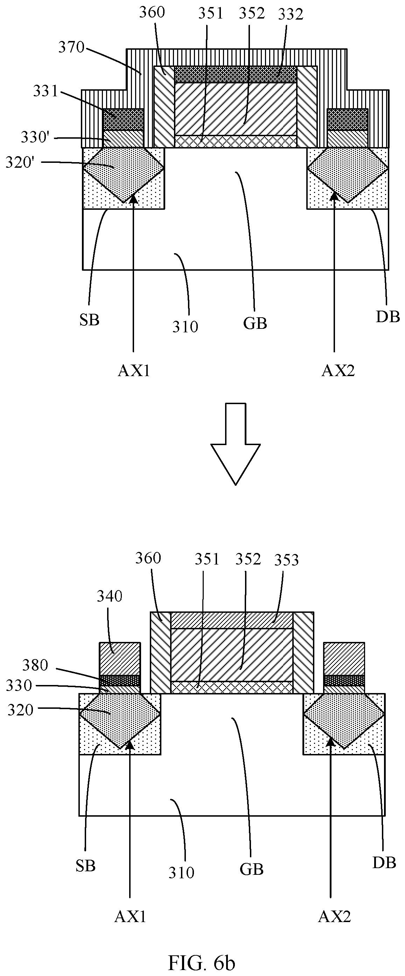

Refer to FIG. 6b. FIG. 6b is a diagram of another structure of the semiconductor device in the preparation process according to an embodiment of this application. For example, a self-aligned silicide process is performed on the amorphous silicon layer 331 to form a metal silicide layer, and the second barrier layer 380 is formed between the metal silicide and a first barrier layer 330. Specifically, a deposition process (for example, a physical vapor deposition process based on a physical vapor deposition device) is employed to deposit a metal layer on a side that is of a silicon capping layer 330' and that faces away from a semiconductor substrate 310, and a thickness of the metal layer approximately ranges from 40 to 80 nanometers. Then, a rapid thermal annealing device is employed to form a high-resistivity metal silicide layer through low-temperature rapid thermal annealing. Because metal ions are implanted and the C ions are displaced, the second barrier layer 380 doped with the C ions is formed between the metal silicide and the first barrier layer 330. Then, a wet etcher is employed to remove a remaining unreacted metal layer through selective etching (a selective etching solution is sulfuric acid). Then, the rapid thermal annealing device is employed to form a low-resistance metal silicide layer through high-temperature rapid thermal annealing. If the metal layer is a cobalt metal layer, the metal silicide is cobalt silicide. An annealing temperature corresponding to low-temperature rapid thermal annealing is approximately 380 to 540 degrees Celsius, and an annealing time is approximately 30 to 120 seconds. An annealing temperature corresponding to high-temperature rapid thermal annealing is approximately 700 to 900 degrees Celsius, and an annealing time is approximately 5 to 30 seconds. If the metal layer is a nickel metal layer, the metal silicide is nickel silicide. An annealing temperature corresponding to low-temperature rapid thermal annealing is approximately 200 to 300 degrees Celsius, and an annealing time is approximately 30 to 60 seconds. An annealing temperature corresponding to high-temperature rapid thermal annealing is approximately 300 to 550 degrees Celsius, and an annealing time is approximately 5 to 30 seconds. If the metal layer is a titanium metal layer, the metal silicide is titanium silicide. Annealing temperatures and annealing times corresponding to low-temperature rapid thermal annealing and high-temperature rapid thermal annealing may be determined according to a process requirement.

An embodiment of this application further provides an electronic device. The electronic device includes a circuit board and a semiconductor device. The semiconductor device is disposed on the circuit board and electrically connected to the circuit board. The semiconductor device is any semiconductor device in embodiments of this application. In addition, the electronic device includes various terminal devices and electronic components. The terminal device may include but is not limited to a device, for example, a smartphone, a smart television, a smart television set-top box, a smartwatch, a personal computer (personal computer, PC), a wearable device, or a smart broadband. The electronic component includes but is not limited to a communication device, for example, a wireless network, a fixed network, and a server, and a component, for example, a component module, a memory, a static random access memory, and a digital logic circuit, which are not listed one by one herein. It may be understood that a specific implementation of the semiconductor device may be determined based on an actual application scenario. This is not limited in this application.

The foregoing content is merely specific implementations of this application, but is not intended to limit the protection scope of this application. Any variation or replacement readily figured out by a person skilled in the art within the technical scope disclosed in this application shall fall within the protection scope of this application.

## Claims

1. A semiconductor device, comprising:
a semiconductor substrate, wherein the semiconductor substrate comprises a channel region and a source region and a drain region that are located on two sides of the channel region, recesses are formed in the source region and the drain region, and a first semiconductor material is filled in the recesses;
a first barrier layer, located on the source region and the drain region, wherein orthographic projections of the first barrier layer onto the semiconductor substrate respectively overlap orthographic projections of opening portions of the recess in the source region and the recess in the drain region onto the semiconductor substrate, and the first barrier layer comprises a second semiconductor material doped with first dopant ions;
a metal silicide layer, covering a side that is of the first barrier layer on the source region and the drain region and that faces away from the semiconductor substrate, wherein a lattice structure of a material of the metal silicide layer is different from a lattice structure of the first semiconductor material;
a gate stack structure, located on the channel region, wherein the gate stack structure comprises a gate dielectric layer and a gate, and the gate dielectric layer is located between the gate and the channel region; and
gate spacers, located on two sides of the gate stack structure, wherein an orthographic projection of the gate spacer onto the semiconductor substrate does not overlap the opening portion of the recess.

2. The semiconductor device according to claim 1, wherein the second semiconductor material comprises Si; and
the semiconductor device is a P-type transistor, and the first dopant ions are B ions, or the first dopant ions are B ions and C ions.

3. The semiconductor device according to claim 1 or 2, wherein the metal silicide layer comprises one or more of cobalt silicide, nickel silicide, and titanium silicide; and/or
the semiconductor device is the P-type transistor, and the first semiconductor material comprises a silicon-germanium material.

4. The semiconductor device according to any one of claims 1 to 3, further comprising a second barrier layer, wherein the second barrier layer is located between the metal silicide layer and the first barrier layer on the source region and the drain region, and the second barrier layer comprises a third semiconductor material doped with second dopant ions.

5. The semiconductor device according to claim 4, wherein the second dopant ions comprise C ions.

6. The semiconductor device according to any one of claims 1 to 5, wherein the gate stack structure further comprises the metal silicide layer covering a side that is of the gate and that faces away from the semiconductor substrate.

7. The semiconductor device according to any one of claims 1 to 6, wherein, in a direction from the bottom of the recess to the opening portion of the recess, a cross-sectional area of the recess at a first cross section gradually increases to a target cross-sectional area and then gradually decreases from the target cross-sectional area, the first cross section is parallel to a plane on which the opening portion of the recess is located, and the first cross section is located between the opening portion and the bottom of the recess.

8. An electronic device, comprising a circuit board and the semiconductor device according to any one of claims 1 to 7, wherein the semiconductor device is disposed on the circuit board.

9. A method for preparing a semiconductor device, comprising:
forming a gate stack structure on a channel region of the semiconductor substrate, and gate spacers located on two sides of the gate stack structure, wherein the gate stack structure comprises a gate dielectric layer and a gate, the gate dielectric layer is located between the gate and the channel region, and an orthographic projection of the gate spacer onto the semiconductor substrate does not overlap an opening portion of the recess;
etching recesses in a source region and a drain region of the semiconductor substrate, respectively;
epitaxially growing a first semiconductor material in the recesses; and
performing ion doping in the source region and the drain region of the semiconductor substrate, and forming a first barrier layer and a metal silicide on the source region and the drain region, wherein orthographic projections of the first barrier layer onto the semiconductor substrate respectively overlap orthographic projections of opening portions of the recess in the source region and the recess in the drain region onto the semiconductor substrate, the first barrier layer comprises a second semiconductor material doped with first dopant ions, and the metal silicide layer covers a side that is of the first barrier layer on the source region and the drain region and that faces away from the semiconductor substrate.

10. The preparation method according to claim 9, wherein performing the ion doping in the source region and the drain region of the semiconductor substrate and forming the first barrier layer and the metal silicide on the source region and the drain region comprise:
epitaxially forming a silicon capping layer doped with B ions on the source region and the drain region, wherein orthographic projections of the silicon capping layer onto the semiconductor substrate respectively overlap the orthographic projections of the opening portions of the recess in the source region and the recess in the drain region onto the semiconductor substrate, and a doping concentration of the B ions in the silicon capping layer ranges from 8e²⁰ ions per cubic centimeter to 8e²¹ ions per cubic centimeter;
performing doping with the B ions in the source region, the drain region, and the silicon capping layer of the semiconductor substrate, wherein a doping concentration of the B ions in the silicon capping layer ranges from 1e²¹ ions per cubic centimeter to 8e²¹ ions per cubic centimeter;
performing, by using noble gas ions, pre-amorphization implant treatment on at least one side that is of the silicon capping layer and that faces away from the semiconductor substrate, to form an amorphous silicon layer on the side that is of the silicon capping layer and that faces away from the semiconductor substrate; and
forming the metal silicide layer by performing a self-aligned silicide process on the amorphous silicon layer.

11. The preparation method according to claim 10, wherein after the performing, by using the noble gas ions, the pre-amorphization implant treatment on at least one side that is of the silicon capping layer and that faces away from the semiconductor substrate, to form the amorphous silicon layer on the side that is of the silicon capping layer and that faces away from the semiconductor substrate, the method further comprises: implanting C ions into the amorphous silicon layer; and
forming the metal silicide layer by performing the self-aligned silicide process on the amorphous silicon layer comprises: forming the metal silicide layer by performing the self-aligned silicide process on the amorphous silicon layer, to form a second barrier layer between the metal silicide and the first barrier layer.
